(19) Europäisches Patentamt / European Patent Office / Office européen des brevets

(11) **EP 3 283 849 B1**

(12) **EUROPÄISCHE PATENTSCHRIFT**

(45) Veröffentlichungstag und Bekanntmachung des Hinweises auf die Patenterteilung:
**08.06.2022  Patentblatt 2022/23**

(21) Anmeldenummer: **15729141.0**

(22) Anmeldetag: **11.06.2015**

(51) Internationale Patentklassifikation (IPC):
**G01D 5/14** *(2006.01)*    **G01D 5/244** *(2006.01)*
**G01D 3/08** *(2006.01)*

(52) Gemeinsame Patentklassifikation (CPC):
**G01D 5/145; G01D 3/08; G01D 5/24461; G01D 5/24485**

(86) Internationale Anmeldenummer:
**PCT/EP2015/063057**

(87) Internationale Veröffentlichungsnummer:
**WO 2016/198111 (15.12.2016 Gazette 2016/50)**

(54) **ANTRIEBSVORRICHTUNG MIT ERFASSUNGSEINRICHTUNG UND VERFAHREN**

DRIVE DEVICE WITH DETECTION APPARATUS AND METHOD

DISPOSITIF D'ENTRAÎNEMENT MUNI D'UN SYSTÈME DE DÉTECTION ET PROCÉDÉ ASSOCIÉ

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(43) Veröffentlichungstag der Anmeldung:
**21.02.2018  Patentblatt 2018/08**

(73) Patentinhaber: **Festo SE & Co. KG
73734 Esslingen (DE)**

(72) Erfinder:
• **QUAAS, Jörg
73760 Ostfildern (DE)**
• **BRAUN, Manuel
70567 Stuttgart (DE)**
• **TRAPASSO, Franco
70184 Stuttgart (DE)**

(74) Vertreter: **Patentanwälte Magenbauer & Kollegen Partnerschaft mbB
Plochinger Straße 109
73730 Esslingen (DE)**

(56) Entgegenhaltungen:
EP-A1- 1 777 501        DE-T2- 69 510 357
US-A1- 2005 189 938     US-A1- 2013 027 028

**Beschreibung**

Die Erfindung betrifft eine Antriebsvorrichtung zur Bereitstellung einer Antriebsbewegung eines Antriebskörpers, umfassend den Antriebskörper, der eine Magnetanordnung umfasst, wobei die Antriebsvorrichtung wenigstens zwei voneinander beabstandete Magnetfeldsensorelemente umfasst, die ausgebildet sind, Magnetfeldmesswerte bereitzustellen, und einer Erfassungseinrichtung, die ausgebildet ist, eine Position des Antriebskörpers basierend auf einem oder mehreren der Magnetfeldmesswerte zu erfassen.

Insbesondere betrifft die Erfindung eine in der Prozesstechnik oder Prozessautomation eingesetzte Antriebsvorrichtung, die dazu dient, einen linearbeweglich gelagerten Ventilkörper eines Prozessventils über einen Antriebskörper anzutreiben und die aktuelle Position des Antriebskörpers mittels der Erfassungseinrichtung zu erfassen. Bei einer solchen Antriebsvorrichtung ist der Antriebskörper beispielsweise als Stange ausgebildet und wird vorzugsweise pneumatisch oder elektrisch angetrieben.

Die Erfindung betrifft ferner ein Verfahren, bei welchem wenigstens zwei Magnetfeldmesswerte mittels wenigstens zweier voneinander beabstandeter Magnetfeldsensorelemente erfasst werden.

Aus der DE 695 10 357 T2 ist eine Vorrichtung zur Erfassung einer Position eines Magneten mittels einer Vielzahl von magnetischen Feldwandlern bekannt. Die Wandler geben eine Vielzahl von Ausgangs-Signalwerten entsprechend der Position des Magneten aus. Die Ausgangs-Signalwerte werden an eine Kurve angepasst. Aus dem Nullpunkt der Kurve wird auf die Position des Magneten relativ zu der Anordnung von Wandlern geschlossen.

Bei einer solchen Vorrichtung kann es allerdings vorkommen, dass externe Störeinflüsse, wie zum Beispiel Temperaturschwankungen oder eingestreute Magnetfelder, die Wandlungscharakteristik der Feldwandler beeinflussen, wodurch die Genauigkeit der Positionserfassung beeinträchtigt wird. In einem solchen Fall gibt die aus dem Stand der Technik bekannte Vorrichtung weiterhin Positionswerte aus und es besteht keine Möglichkeit, zu überprüfen, inwieweit diese Positionswerte überhaupt valide bzw. gültig sind. Dies kann zu einer Beeinträchtigung der Betriebssicherheit führen, z.B. wenn Aktoren basierend auf den ungenau erfassten bzw. ungültigen Positionswerten angesteuert werden.

Die EP 1 777 501 A1 beschreibt einen Positionssensor mit wenigstens zwei Sensorelementen, wobei jedes Sensorelement im magnetischen Einflussbereich eines anderes Pols einer Gebereinheit angeordnet ist. Zur Korrektur von Störungen sind mindestens zwei Sensorelemente erforderlich. Die jeweiligen Signale werden jeweils einem Drehwinkel zugeordnet. Falls sich diese Drehwinkel um mehr als die zulässige Toleranz unterscheiden, liegt entweder ein Störfeld vor oder mindestens ein Sensor ist defekt.

Die US 2005/0189938 A1 beschreibt ein Positionserfassungssystem mit einer Mehrzahl an Sensoren. Ein Sensorfehler wird auf Basis einer Inkonsistenz eines Signals mit restlichen Signalen detektiert.

Es ist eine Aufgabe der Erfindung eine Antriebsvorrichtung der eingangs beschriebenen Art bereitzustellen, mit welcher ein erhöhtes Maß an Betriebssicherheit gewährleistet werden kann.

Diese Aufgabe wird für eine Antriebsvorrichtung der eingangs beschriebenen Art mit den Merkmalen des Anspruchs 1 gelöst. Die erfindungsgemäße Antriebsvorrichtung umfasst eine Erfassungseinrichtung, die ausgebildet ist, gemäß wenigstens zwei Magnetfeldmesswerten von wenigstens zwei als auf demselben Chip befindliche Pixelzellen derselben Sensorzelle ausgebildete Magnetfeldsensorelementen oder gemäß wenigstens zwei Positionswerten, die auf wenigstens zwei Magnetfeldmesswerten basieren, die von wenigstens zwei als auf demselben Chip befindliche Pixelzellen derselben Sensorzelle ausgebildete Magnetfeldsensorelementen erfasst werden, sowie unter Einbeziehung einer Prüfinformation, die eine Soll-Beziehung zwischen Magnetfeldmesswerten bzw. zwischen Positionswerten darstellt, die Validität der Positionserfassung zu prüfen und in Abhängigkeit von dem Ergebnis der Prüfung ein Validitätssignal bereitzustellen.

Erfindungsgemäß wird folglich eine Information - das Validitätssignal - bereitgestellt, die angibt, ob die Positionserfassung valide bzw. gültig ist oder nicht. Gegenüber dem oben genannten Stand der Technik ergibt sich somit der Vorteil, dass eingeschätzt werden kann, ob die von der Erfassungseinrichtung erfasste Position des Antriebskörpers verlässlich ist bzw. inwieweit diese der tatsächlichen Position des Antriebskörpers entspricht. Die Bereitstellung einer solchen Information erhöht die Betriebssicherheit, da sie es ermöglicht, eventuelle Beeinträchtigungen der Positionserfassungsgenauigkeit kenntlich zu machen und/oder entsprechende Maßnahmen einzuleiten. Damit kann die Wahrscheinlichkeit, dass es aufgrund einer unbemerkten fehlerhaften Positionserfassung eines Antriebskörpers zu Schäden kommt, reduziert werden. Die Erfassungseinrichtung ist ausgebildet, die Validitätsprüfung gemäß wenigstens zwei Magnetfeldmesswerten, die von wenigstens zwei als Pixelzellen derselben Sensorzelle ausgebildeten Magnetfeldsensorelementen erfasst werden, oder gemäß Positionswerten, die auf diesen Magnetfeldmesswerten basieren, durchzuführen. Die Pixelzellen befinden sich auf demselben Chip.

Die Verwendung von Magnetfeldmesswerten bzw. Positionswerten von zwei als Pixelzellen derselben Sensorzelle ausgebildeten Magnetfeldsensorelementen ist besonders vorteilhaft, da der Abstand zwischen diesen Pixelzellen in der Regel sehr genau definiert ist. Insbesondere weist der Abstand zwischen zwei Pixelzellen derselben Sensorzelle im Gegensatz zu dem Abstand zwischen zwei Pixelzellen verschiedener Sensorzellen keine durch einen Lötprozess verursachten Toleranzen auf. Dies ist insbesondere dann der Fall, wenn sich die beiden Pixelzellen auf demselben Chip befinden.

Erfindungsgemäß werden für die Validitätsprüfung dabei Magnetfeldmesswerte oder darauf basierte Positionswerte von Magnetfeldsensorelementen verwendet, die bereits der Erfassung der Position des Antriebskörpers dienen. Das heißt, dass die bereits zur Positionserfassung vorhandenen Magnetfeldsensorelemente nun auch für die Validitätsprüfung eingesetzt werden, so dass für die erfindungsgemäße Validitätsprüfung keine zusätzlichen Sensoren vorgesehen werden müssen. Dies erzielt den Vorteil, dass die vorliegende Erfindung in einfacher und kostengünstiger Weise realisiert werden kann.

Zur Überprüfung, ob die Positionserfassung valide ist oder nicht, werden wenigstens zwei Magnetfeldmesswerte von zwei voneinander beabstandeten Magnetfeldsensorelementen eingesetzt. Vorzugsweise wird dabei je ein Magnetfeldmesswert von einem Magnetfeldsensorelement verwendet. Als Magnetfeldmesswert wird in diesem Zusammenhang ein Signal verstanden, das eine von einem Magnetfeldsensorelement erfasste ortsabhängige Eigenschaft eines Magnetfelds darstellt. Ein Magnetfeldmesswert kann dabei eine oder mehrere Komponenten aufweisen, das heißt, ein- oder mehrdimensional sein bzw. ein Skalar oder einen Vektor umfassen. Vorzugsweise umfasst ein Magnetfeldmesswert zwei Magnetfeldstärken in zwei linear unabhängigen Richtungen. Zum Beispiel umfasst ein Magnetfeldmesswert die Stärke einer Magnetfeldkomponente längs der Antriebsbewegung des Antriebskörpers und die Stärke einer Magnetfeldkomponente senkrecht zur Antriebsbewegung. Die Richtung der Antriebsbewegung wird im Folgenden auch als Axialrichtung und die zur Antriebsbewegung senkrechte Richtung als Radialrichtung bezeichnet. Die beiden Magnetfeldstärken können hierbei natürlich auch in Polarkoordinaten - also als Winkel und Betrag - ausgedrückt sein.

Alternativ zu den beiden Magnetfeldmesswerten werden zur Validitätsprüfung wenigstens zwei von den Magnetfeldmesswerten abgeleitete Positionswerte verwendet. Als Positionswert soll in diesem Zusammenhang jeder Wert bezeichnet werden, mittels welchem auf eine Positionsbeziehung zwischen einem Magnetfeldsensorelement und der Magnetanordnung des Antriebskörpers geschlossen werden kann. Die Positionswerte können beispielsweise anhand einer Funktion oder einer Wertetabelle aus den Magnetfeldmesswerten berechnet werden.

Bei der Validitätsprüfung wird nun zudem eine Prüfinformation mit einbezogen, die eine Soll-Beziehung zwischen Magnetfeldmesswerten bzw. zwischen Positionswerten darstellt. Dieser Ansatz beruht auf der Annahme, dass im validen Zustand, also in dem Zustand, in dem die Positionserfassung mit der erforderlichen Genauigkeit erfolgt, die Magnetfeldmesswerte bzw. Positionswerte von wenigstens zwei voneinander beabstandeten Magnetfeldsensorelementen in der Regel eine ganz bestimmte Beziehung zueinander aufweisen. Wenn nämlich, wie dies im validen Zustand der Fall ist, der Zusammenhang zwischen erfassten Magnetfeldmesswerten und relativem Abstand der Magnetanordnung einer vorgegebenen Gesetzmäßigkeit folgt und der Abstand zwischen zwei voneinander beabstandeten Magnetfeldsensorelementen fest ist, so muss im validen Zustand auch die Beziehung zweier von diesen Magnetfeldsensorelementen erhaltenen Magnetfeldmesswerten einer vorgegebenen Gesetzmäßigkeit folgen.

Folglich kann über eine Prüfung der Beziehung von Magnetfeldmesswerten von zwei voneinander beabstandeten Magnetfeldsensorelementen darauf geschlossen werden, ob die Positionserfassung valide ist. Diese vorgegebene Gesetzmäßigkeit, welcher die beiden Magnetfeldmesswerte im validen Zustand relativ zueinander folgen sollen, wird in diesem Zusammenhang als Soll-Beziehung bezeichnet. Die Soll-Beziehung wird durch die Prüfinformation dargestellt bzw. ist in dieser enthalten. Beispielsweise definiert die Prüfinformation für jeden von einem ersten Magnetfeldsensorelement erfassten ersten Magnetfeldmesswert einen bestimmten Wertebereich, in welchem ein zweiter Magnetfeldmesswert von einem von dem ersten Magnetfeldsensorelement beabstandeten zweiten Magnetfeldsensorelement liegen müsste, wenn die Positionserfassung valide ist. Liegt nun der zweite Magnetfeldmesswert nicht in diesem Wertebereich, so ist die Positionserfassung nicht valide und die Erfassungseinrichtung gibt ein entsprechendes Validitätssignal aus.

Wie bereits vorstehend beschrieben, kann die Validitätsprüfung auch basierend auf zwei von den beiden Magnetfeldmesswerten abgeleiteten Positionswerten durchgeführt werden. In diesem Fall kann die Prüfinformation beispielsweise für einen ersten von einem ersten Magnetfeldsensorelement stammenden Positionswert einen bestimmten Wertebereich definieren, in welchem ein zweiter von einem zweiten Magnetfeldsensorelement stammender Positionswert liegen müsste, wenn die Positionserfassung valide ist. Alternativ dazu kann die Prüfinformation auch einen bestimmten Wertebereich definieren, in welchem die Differenz zweier von zwei verschiedenen Magnetfeldsensorelementen stammenden Positionswerten liegen müsste, wenn die Positionserfassung valide ist.

Wird bestimmt, dass die Positionserfassung nicht valide ist, so stellt die Erfassungseinrichtung ein entsprechendes Validitätssignal bereit. Zum Beispiel kann die Erfassungseinrichtung ein entsprechendes Validitätssignal an eine andere Einrichtung, wie zum Beispiel eine Schnittstelleneinrichtung, ausgeben. Alternativ oder zusätzlich dazu kann das Validitätssignal auch intern in der Erfassungseinrichtung bereitgestellt werden, und dort zum Beispiel als Datum abgespeichert werden.

Vorzugsweise kann das Validitätssignal mindestens zwei verschiedene Werte annehmen, wobei ein Wert anzeigt, dass die Positionserfassung valide ist, und der andere Wert anzeigt, dass die Positionserfassung nicht valide ist.

Als Magnetfeldsensorelemente können beispielsweise HallSensoren dienen. Vorzugsweise werden 2D- oder 3D-HallSensoren eingesetzt. Zweckmäßiger Weise können 3D-HallSensoren eingesetzt werden, wobei der Validitätsprüfung dann jeweils nur 2D-Magnetfeldkomponenten - also gemessene Magnetfeldstärken in zwei Raumrichtungen - zu Grunde gelegt werden. Die einzelnen Magnetfeldsensorelemente können beispielsweise als Pixelzellen ausgebildet sein, die in Sensorzellen angeordnet sind. Beispielsweise umfasst jede Sensorzelle zwei oder mehr Magnetfeldsensorelemente.

Die Magnetfeldsensorelemente sind beabstandet zum Antriebskörper angeordnet. Vorzugsweise umfasst die Antriebsvorrichtung den Antriebskörper und der Antriebskörper ist längs eines Verschiebewegs verschiebbar. Vorzugsweise sind die Magnetfeldsensorelemente derart angeordnet, dass sich der Abstand zwischen den Magnetfeldsensorelementen und der Magnetanordnung bei Durchführung der Antriebsbewegung ändert. Zweckmäßigerweise können die Magnetfeldsensorelemente entlang einer gedachten Linie angeordnet sein, die zumindest teilweise parallel zum Verschiebeweg bzw. zur Antriebsbewegung verläuft.

Die Magnetanordnung ist vorzugsweise ein am Antriebskörper befestigter Permanentmagnet. Alternativ dazu kann die Magnetanordnung auch in den Antriebskörper eingelassen sein oder selbst den Antriebskörper darstellen. Die Polrichtung der Magnetanordnung weist eine bestimmte Ausrichtung relativ zur Antriebsbewegung auf. Insbesondere ist die Magnetanordnung axial polarisiert, so dass die Polrichtung der Magnetanordnung parallel zu der Antriebsbewegung ausgerichtet ist. Zweckmäßigerweise ist die Magnetanordnung in der Form einer Scheibe ausgebildet, wobei die Polrichtung normal zur kreisförmigen Grundfläche der Scheibe ausgerichtet ist.

Vorteilhafte Weiterbildungen der Erfindung sind Gegenstand der abhängigen Ansprüche.

Bei einer Ausgestaltung der Erfindung ist vorgesehen, dass die Antriebsvorrichtung den Antriebskörper umfasst und der Antriebskörper längs eines Verschiebewegs verschiebbar ist. In weiterer Ausgestaltung der Erfindung ist vorgesehen, dass die Erfassungseinrichtung ausgebildet ist, unter Verwendung eines oder mehrerer Initialisierungsparameter jeweils einen Magnetfeldmesswert von einem Magnetfeldsensorelement in einen Positionswert umzusetzen.

Vorzugsweise ist die Erfassungseinrichtung demnach ausgebildet, jeweils einen Magnetfeldmesswert direkt in einen Positionswert umzusetzen. Aus dem Positionswert, der zum Beispiel die Position der Magnetanordnung relativ zum entsprechenden Magnetfeldsensorelement angibt, kann dann unter Berücksichtigung der Position des Magnetfeldsensorelements die Position der Magnetanordnung relativ zu einem bestimmten Referenzpunkt bestimmt werden. Im Gegensatz dazu werden bei dem vorstehend genannten Stand der Technik Magnetfeldmesswerte von mehreren Magnetfeldsensorelementen benötigt, um die Position einer Magnetanordnung zu bestimmen.

Für die direkte Umsetzung bzw. Abbildung eines Magnetfeldmesswerts in einen Positionswert werden ein oder mehrere Initialisierungsparameter verwendet. Der oder die Initialisierungsparameter dienen insbesondere dazu, die Geometrie bzw. den räumlichen Verlauf des von der Magnetanordnung erzeugten Magnetfelds bzw. die Ausrichtung dessen Magnetfeldlinien zu beschreiben. Vorzugsweise dienen die Initialisierungsparameter dazu, einen Zusammenhang zwischen der Position der Magnetanordnung relativ zu einem Magnetfeldsensorelement und des von diesem Magnetfeldsensorelement erfassten Magnetfeldmesswerts zu definieren. Die Initialisierungsparameter können dabei Konstanten sein, die in ein entsprechendes Magnetfeldmodell bzw. eine entsprechende Funktion oder einen Algorithmus eingesetzt werden. Vorzugsweise weist die Erfassungseinrichtung einen Speicher auf, um die Initialisierungsparameter und/oder das Magnetfeldmodell zu speichern.

In weiterer Ausgestaltung der Erfindung ist vorgesehen, dass die Erfassungseinrichtung ausgebildet ist, auf Basis von erfassten Magnetfeldmesswerten den bzw. die Initialisierungsparameter zu bestimmen.

Vorzugsweise ist die Antriebsvorrichtung ausgebildet, den bzw. die vorstehend beschriebenen Initialisierungsparameter selbstständig zu ermitteln. Dies kann vorzugsweise dadurch erfolgen, dass mit drei voneinander beabstandeten Magnetfeldsensorelementen das Magnetfeld der Magnetanordnung gemessen wird, indem drei Magnetfeldmesswerte erfasst werden. Auf Basis der erfassten Magnetfeldmesswerte, der relativen Abstände der Magnetfeldsensorelemente zueinander und eines mathematischen Modells, das die Magnetfeldmesswerte in Beziehung mit der Position der Magnetanordnung setzt, kann dann ein Gleichungssystem aufgestellt werden, dessen Lösung den bzw. die Initialisierungsparameter ergibt.

Wenn es möglich ist, die Magnetanordnung an eine bekannte Position wie z.B. eine Endposition zu bewegen, können die Initialisierungsparameter alternativ zu dem vorstehend beschriebenen Ansatz auch auf Basis von nur zwei erfassten Magnetfeldmesswerten ermittelt werden. Die Bestimmung der Initialisierungsparameter findet vorzugsweise unter kontrollierten Bedingungen statt, also wenn beispielsweise gewährleistet werden kann, dass kein externes Magnetfeld einstreut, so dass die erfassten Magnetfeldmesswerte lediglich auf dem Magnetfeld der Magnetanordnung beruhen.

Für die Bestimmung der Initialisierungsparameter werden vorzugsweise die Magnetfeldmesswerte verwendet, die die größte Magnetfeldstärke anzeigen. Dies erhöht die Genauigkeit der Bestimmung, da bei diesen Magnetfeldmesswerten der Signal-Rauschabstand am höchsten bzw. der Fehler der Positionserfassung am geringsten ist.

In weiterer Ausgestaltung der Erfindung ist vorgesehen, dass die Erfassungseinrichtung ausgebildet ist, gemäß dem Validitätssignal den bzw. die Initialisierungsparameter neu zu bestimmen.

In bestimmten Fällen, insbesondere wenn es zu quasistationären Änderungen der Umgebungseigenschaften kommt, verändert sich der Zusammenhang zwischen der Position der Magnetanordnung und dem von einem Magnetfeldsensorelement erfassten Magnetfeldmesswert. Die Initialisierungsparameter sind dann nicht mehr dazu geeignet, auf Basis eines Magnetfeldmesswerts eine genaue Position der Magnetanordnung zu ermitteln. Dies lässt sich, wie bereits vorstehend beschrieben, insbesondere dadurch feststellen, dass geprüft wird, ob die Beziehung zweier Positionswerte, die von verschiedenen Magnetfeldsensorelementen stammen, einer Soll-Beziehung entspricht oder nicht.

Wird nun eine Abweichung von der Soll-Beziehung festgestellt so wird, wie ebenfalls vorstehend beschrieben, ein entsprechendes Validitätssignal bereitgestellt. Vorzugsweise ist die Erfassungseinrichtung nun dazu ausgebildet, in diesem Fall, also wenn das Validitätssignal anzeigt, dass die Positionserfassung nicht valide ist, eine neue Bestimmung der Initialisierungsparameter vorzunehmen. Die neu bestimmten Initialisierungsparameter berücksichtigen dann die vorstehend genannte quasistationäre Veränderung der Umgebungseigenschaften und sind somit wieder dazu geeignet, auf Basis eines Magnetfeldmesswerts eine genaue Position der Magnetanordnung zu ermitteln.

Vorzugsweise ist die Neubestimmung der Initialparameter von einem von einer externen Steuereinheit empfangenen Befehl abhängig. Insbesondere ist die Erfassungseinrichtung ausgebildet, die Neubestimmung nur dann vorzunehmen, wenn ein entsprechender Befehl vorliegt.

In weiterer Ausgestaltung der Erfindung ist vorgesehen, dass die Antriebsvorrichtung ausgebildet ist, in Abhängigkeit von dem Validitätssignal ein Fehlersignal auszugeben und/oder einen sicheren Zustand einzunehmen.

Vorzugsweise ist die Antriebsvorrichtung ausgebildet, über eine Schnittstellenvorrichtung ein Fehlersignal an eine übergeordnete Steuereinheit auszugeben, wenn das Validitätssignal anzeigt, dass die Positionserfassung nicht valide ist. Alternativ oder zusätzlich dazu kann die Antriebsvorrichtung auch ausgebildet sein, in diesem Fall ein akustisches oder optisches Warnsignal auszugeben, um so einen Benutzer der Antriebsvorrichtung direkt zu warnen, dass eine sichere Positionserfassung nicht mehr gewährleistet werden kann.

Vorzugsweise ist die Antriebsvorrichtung ferner ausgebildet, in dem Fall, in dem die Positionserfassung nicht valide ist, einen sicheren Zustand einzunehmen. Das kann beispielsweise dadurch erfolgen, dass der Antriebskörper in eine vorbestimmte Stellung bewegt wird. Alternativ oder zusätzlich dazu kann auch die auf den Antriebskörper beaufschlagte Kraft abgesenkt bzw. abgeschaltet werden.

In weiterer Ausgestaltung der Erfindung ist vorgesehen, dass die Erfassungseinrichtung ausgebildet ist, wenigstens zwei Magnetfeldmesswerte, die jeweils die größte Magnetfeldstärke anzeigen, auszuwählen und die Validitätsprüfung gemäß den ausgewählten Magnetfeldmesswerten bzw. gemäß Positionswerten, die auf den ausgewählten Magnetfeldmesswerten basieren, durchzuführen.

Die Validitätsprüfung kann am genauesten mit Magnetfeldmesswerten von den Magnetfeldsensorelementen durchgeführt werden, die am nächsten zu der Magnetanordnung liegen und dadurch das stärkste Magnetfeld erfahren. Um diesen Effekt zu nutzen, ist es vorteilhaft, für die Validitätsprüfung jeweils die Magnetfeldmesswerte auszuwählen, die die größten Magnetfeldstärken anzeigen. Alternativ dazu können für die Validitätsprüfung natürlich auch die Positionswerte ausgewählt werden, die den geringsten Abstand zur Magnetanordnung anzeigen.

In weiterer Ausgestaltung der Erfindung ist vorgesehen, dass die Erfassungseinrichtung ausgebildet ist, die Validitätsprüfung gemäß wenigstens zwei Magnetfeldmesswerten, die von wenigstens zwei benachbarten Magnetfeldsensorelementen erfasst werden, bzw. gemäß Positionswerten, die auf diesen Magnetfeldmesswerten basieren, durchzuführen.

In der Regel kann die Soll-Beziehung zwischen zwei benachbarten Magnetfeldsensorelementen genau definiert werden. Dies ist insbesondere der Fall, wenn die Soll-Beziehung den Abstand zwischen zwei Magnetfeldsensorelementen darstellt. Daher ist es vorteilhaft, der Validitätsprüfung Magnetfeldmesswerte bzw. Positionswerte von zwei benachbarten Magnetfeldsensorelementen zu Grunde zu legen.

In weiterer Ausgestaltung der Erfindung ist vorgesehen, dass die Soll-Beziehung den Abstand zwischen zwei Magnetfeldsensorelementen darstellt oder auf diesem basiert.

Die Soll-Beziehung kann dabei insbesondere einen Wertebereich definieren, in dem die Differenz zwischen zwei Positionswerten im validen Zustand liegen müsste. Wenn die einzelnen Positionswerte jeweils die relative Position der Magnetanordnung zu dem jeweiligen Magnetfeldsensorelement angeben, so sollte im validen Zustand die Differenz der Positionswerte in etwa dem Abstand zwischen den zugehörigen Magnetfeldsensorelementen entsprechen. Ist dies nicht der Fall, so kann die Genauigkeit der Positionserfassung nicht gewährleistet werden und die Erfassungseinrichtung stellt ein entsprechendes Validitätssignal bereit.

Die vorstehend genannte Aufgabe wird ferner gelöst durch das in Anspruch 10 definierte Verfahren zur Validitätsprüfung einer Erfassung einer Position eines Antriebskörpers, der eine Magnetanordnung aufweist, mit den Schritten: Erfassen von wenigstens zwei Magnetfeldmesswerten mittels wenigstens zweier voneinander beabstandeter als auf demselben Chip befindliche Pixelzellen derselben Sensorzelle ausgebildete Magnetfeldsensorelemente, Prüfen der Validität der Positionserfassung gemäß den wenigstens zwei erfassten Magnetfeldmesswerten oder gemäß wenigstens zwei auf den wenigstens zwei Magnetfeldmesswerten basierten Positionswerten sowie unter Einbeziehung einer gespeicherten Prüfinformation, die eine Soll-Beziehung zwischen Magnetfeldmesswerten bzw. zwischen Positionswerten darstellt, und Bereitstellen eines Validitätssignals in Abhängigkeit von dem Ergebnis der Prüfung.

Vorzugsweise ist der Antriebskörper längs eines Verschiebewegs verschiebbar.

Für das Verfahren kann vorzugsweise die vorstehend beschriebene Antriebsvorrichtung bzw. die von dieser umfasste Erfassungseinrichtung eingesetzt werden.

Eine beispielhafte Ausführungsform der Erfindung ist in der Zeichnung dargestellt. Dabei zeigt

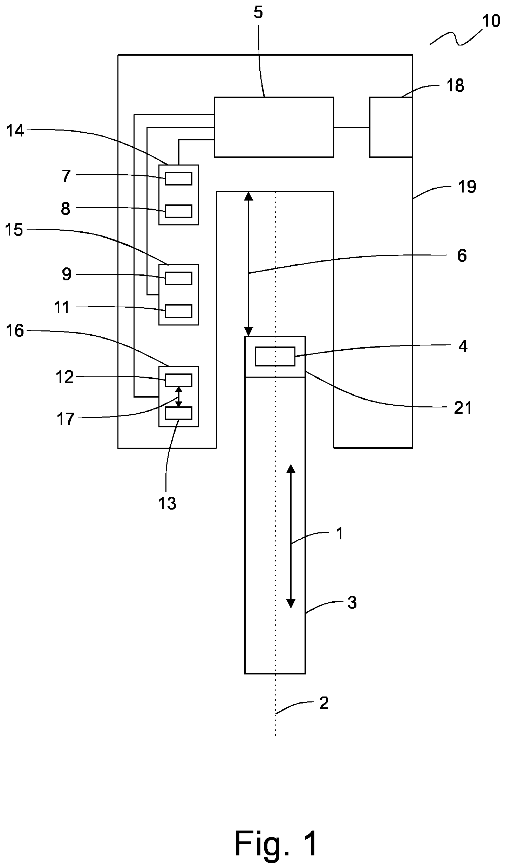

Figur 1      eine schematische Darstellung einer Antriebsvorrichtung.

Die in der Figur 1 gezeigte Antriebsvorrichtung 10 stellt eine beispielhafte Ausführungsform der Erfindung dar. Die Antriebsvorrichtung 10 umfasst einen exemplarisch als Kolbenstange eines nicht dargestellten Pneumatikzylinders ausgebildeten Antriebskörper 3 sowie einen als Stator dienenden Vorrichtungskörper 19. Der Antriebskörper 3 ist entlang des Verschiebewegs 2 relativ zum Vorrichtungskörper 19 verschiebbar, um die Antriebsbewegung 1 auszuführen.

Der Antriebskörper 3 umfasst eine als Permanentmagnet ausgebildete Magnetanordnung 4, die an einem Ende des Antriebskörpers 3 angeordnet ist. Vorzugsweise wird die Magnetanordnung dabei von einem Magnethalter 21 gehalten. Zweckmäßigerweise ist die Magnetanordnung 4 als Pillenmagnet ausgebildet und befindet sich verpresst auf dem Magnethalter 21 am oberen bzw. dem Vorrichtungskörper 19 zugewandten Ende des Antriebskörpers 3.

Die Magnetanordnung 4 ist insbesondere derart angeordnet, dass deren Polrichtung bzw. die durch die Magnetanordnung 4 verlaufenden Magnetfeldlinien parallel zu der Antriebsbewegung 1 und dem Verschiebeweg 2 ausgerichtet sind.

Die Antriebsvorrichtung 10 umfasst ferner die Magnetfeldsensorelemente 7, 8, 9, 11, 12 und 13, die an dem Vorrichtungskörper 19 entlang einer gedachten Linie parallel zu dem Verschiebeweg 2 voneinander beabstandet angeordnet sind. Die Magnetfeldsensorelemente 7, 8, 9, 11, 12 und 13 sind vorzugsweise als 3D-Hallsensoren ausgebildet. In der gezeigten beispielhaften Ausführungsform sind die Magnetfeldsensorelemente 7, 8, 9, 11, 12 und 13 als Pixelzellen paarweise in den Sensorzellen 14, 15 und 16 angeordnet. Die Pixelzellen der Sensorzellen 14, 15 und 16 weisen dabei einen vorbestimmten Abstand 17 zueinander auf.

Die Magnetfeldsensorelemente 7, 8, 9, 11, 12 und 13 sind ausgebildet, Magnetfeldkomponenten wenigstens in Axial- und einer Radial-Richtung des Verschiebewegs 2 zu erfassen und entsprechende Magnetfeldmesswerte an die Erfassungseinrichtung 5 auszugeben. Die Magnetfeldmesswerte können auch jeweils als Polarkoordinaten - also als Winkel und Betrag - ausgedrückt werden, wobei der Betrag die Magnetfeldstärke und der Winkel den Winkel zwischen Axial- und Radialfeld bzw. den entsprechenden Magnetfeldkomponenten darstellt. Vorzugsweise wird der Winkel als ein mit dem CORDIC-Algorithmus berechneter Wert ausgedrückt. Die Ermittlung der Polarkoordinatendarstellung kann in den Magnetfeldsensorelementen 7, 8, 9, 11, 12 und 13 oder der Erfassungseinrichtung 5 erfolgen.

Die Erfassungsvorrichtung 5 ist ausgebildet, die von den Magnetfeldsensorelementen ausgegebenen Magnetfeldmesswerte zu empfangen und auf Basis mindestens eines Magnetfeldmesswertes die Position 6 der Magnetanordnung 4 bzw. des Antriebskörpers 3 relativ zu einem Referenzpunkt des Vorrichtungskörpers 19 zu bestimmen. Im gezeigten Beispiel dient als Referenzpunkt der durch die obere Spitze des Pfeils 6 gekennzeichnete Anschlagspunkt des Vorrichtungskörpers 19.

Im vorliegenden Beispiel ist die Erfassungsvorrichtung 5 ausgebildet, als Position die Auslenkung bzw. Verschiebung des Antriebskörpers 3 entlang des Verschiebewegs 2 relativ zum Referenzpunkt zu erfassen. Vorzugsweise geschieht das mittels eines mathematischen Modells oder eines Algorithmus oder einer Wertetabelle oder einer Funktion, das/der/die vorzugsweise den räumlichen Verlauf des von der Magnetanordnung 4 erzeugten Magnetfelds beschreibt und insbesondere einen Zusammenhang zwischen einem erfassten Magnetfeldmesswert bzw. dessen Winkel und einem Abstand zu einem festgelegten Referenzpunkt im Raum definiert.

Im vorliegenden Beispiel ist die Erfassungseinrichtung 5 ausgebildet, die Position des Antriebskörpers 3 auf Basis eines Magnetfeldmesswerts von einem der Magnetfeldsensorelemente 7, 8, 9, 11, 12 und 13 und der folgenden Funktion (1) zu ermitteln:

$$x = \frac{\tan\left(\frac{W_i}{a}\right)}{b} + c_i$$

Hierbei bezeichnet $W_i$ den gemessenen Winkel zwischen erfasstem Axial- und einem Radialfeld in einem Magnetfeldsensorelement i, a bezeichnet einen ersten Initialisierungsparameter, der die "Streckung" des von der Magnetanordnung 4 erzeugten Magnetfelds in der Axialrichtung des Verschiebewegs 2 beschreibt, b einen zweiten Initialisierungsparameter, der die Streckung des von der Magnetanordnung 4 erzeugten Magnetfelds in einer Radialrichtung beschreibt, x die aktuelle Position des Antriebskörpers 3 auf dem Verschiebeweg 2 relativ zu dem Referenzpunkt, und $c_i$ den Abstand des Magnetfeldsensorelements i zu dem Referenzpunkt. Die Variable x kann in diesem Zusammenhang auch als Positionswert bezeichnet werden.

Vorzugsweise verwendet die Erfassungseinrichtung 5 zur Ermittlung der Position x den Winkel $W_i$ des Magnetfeldmesswerts, dessen Betrag die größte Magnetfeldstärke anzeigt.

Die Erfassungseinrichtung 5 ist ausgebildet, insbesondere vor der erstmaligen Ermittlung eines Positionswerts x die vorstehend genannten Initialisierungsparameter a und b selbständig zu bestimmen. Hierfür verwendet die Erfassungseinrichtung 5 drei Magnetfeldmesswerte von jeweils drei voneinander beabstandeten Magnetfeldsensorelementen. Vorzugsweise werden dabei die Magnetfeldmesswerte mit dem größten Betrag bzw. der größten Magnetfeldstärke verwendet. Im gezeigten Beispiel würde die Erfassungseinrichtung 5 entweder die Magnetfeldmesswerte der Magnetfeldsensorelemente 9, 11 und 12, oder die Magnetfeldmesswerte der Magnetfeldsensorelemente 11, 12 und 13 verwenden, da diese aufgrund ihrer nahen Lage relativ zu der Magnetanordnung 4 den größten Betrag bzw. die größte Magnetfeldstärke aufweisen.

Die Erfassungseinrichtung 5 ist ausgebildet, unter Verwendung der drei ausgewählten Magnetfeldmesswerte ein Gleichungssystem aufzustellen, das aus dreien auf der vorstehend gezeigten Funktion (1) basierten Gleichungen besteht. In das Gleichungssystem werden zudem die Abstände $c_i$ der drei Magnetfeldsensorelemente, von denen die verwendeten Magnetfeldmesswerte stammen, eingesetzt. Die Abstände $c_i$ können im Voraus durch eine optische oder magnetische Vermessung bestimmt werden oder ergeben sich beispielsweise aus dem Chip-Layout. Als Unbekannte verbleiben somit im aufgestellten Gleichungssystem die Initialisierungsparameter a, b und der Positionswert x. Das aufgestellte Gleichungssystem umfasst drei Gleichungen und drei Unbekannte und kann daher eindeutig gelöst werden, um so die Initialisierungsparameter a und b zu ermitteln. Die Erfassungseinrichtung 5 ist ausgebildet, zur Lösung des Gleichungssystems ein bekanntes mathematische Verfahren wie z.B. das Newtonsche Iterationsverfahren einzusetzen.

Die Erfassungseinrichtung 5 weist einen Speicher auf und ist ausgebildet, die ermittelten Initialisierungsparameter in diesen Speicher abzulegen. Alternativ dazu kann die Erfassungseinrichtung 5 auch ausgebildet sein, eine unter Verwendung der Initialisierungsparameter erzeugte mathematische Funktion oder eine entsprechende Wertetabelle in den Speicher abzulegen.

Die Erfassungseinrichtung 5 ist ferner ausgebildet, auf Basis der von den Magnetfeldsensorelementen 7, 8, 9, 11, 12 und 13 erfassten Magnetfeldmesswerte eine Validitätsprüfung der Positionserfassung durchzuführen. Vorzugsweise wendet die Erfassungseinrichtung 5 dafür die vorstehend beschriebene Funktion (1) mit den ermittelten Initialisierungsparametern a und b auf zwei Magnetfeldmesswerte von Magnetfeldsensorelementen derselben Sensorzelle an. Vorzugsweise ist die Erfassungseinrichtung 5 ausgebildet, dafür die Magnetfeldmesswerte der Sensorzelle auszuwählen, deren Magnetfeldsensorelemente die Magnetfeldmesswerte mit den größten Beträgen bzw. Magnetfeldstärken bereitstellen. Im gezeigten Beispiel der Figur 1 wäre dies zum Beispiel aufgrund ihrer nahen Lage zur Magnetanordnung 4 die Sensorzelle 16 mit den beiden Magnetfeldsensorelementen 12 und 13.

Im validen Zustand, also wenn die Initialisierungsparameter a und b bzw. die Funktion (1) dazu geeignet sind, den Zusammenhang zwischen Position des Antriebskörpers 3 und einem erfassten Magnetfeldmesswert bzw. dessen Winkel zu beschreiben, sollte die Anwendung der Funktion (1) auf Magnetfeldmesswerte von zwei verschiedenen Magnetfeldsensorelementen in etwa dieselbe Position des Antriebskörpers 3 ergeben. Die Erfassungseinrichtung 5 ist daher ausgebildet, die Differenz zwischen zwei erhaltenen Positionswerten mit einer Prüfinformation zu vergleichen. Die Prüfinformation dient hier als Schwellenwert und stellt die Soll-Beziehung zwischen den beiden Positionswerten dar. Im beschriebenen Beispiel sollten die erhaltenen Positionswerte in etwa gleich sein, so dass hier als Prüfinformation ein entsprechend kleiner Wert gewählt wird.

Alternativ zu der beschriebenen Ausführungsform ist es auch möglich, dass die Erfassungseinrichtung 5 ausgebildet ist, die Positionswerte mittels einer von der Funktion (1) verschiedenen Funktion zu ermitteln. Beispielsweise kann die Erfassungseinrichtung 5 ausgebildet sein, als Positionswert jeweils die relative Position zwischen der Magnetanordnung 4 und dem jeweiligen Magnetfeldsensorelement zu bestimmen. In diesem Fall ist die Erfassungseinrichtung 5 ferner ausgebildet, bei der Validitätsprüfung zu prüfen, ob die Differenz zwischen den beiden ermittelten Positionswerten in etwa dem Abstand zwischen den beiden Magnetfeldsensorelementen entspricht. In diesem Fall dient also der Abstand zwischen den beiden Magnetfeldsensorelementen als die durch die Prüfinformation dargestellte Soll-Beziehung.

Wenn nun eine Änderung der Umgebungseigenschaften seit der Bestimmung der Initialisierungsparameter auftritt, so dass die Anwendung der vorstehend beschriebenen Funktion (1) nicht mehr die tatsächliche Position des Antriebskörpers 3 ergibt, dann wird auch die Differenz zwischen den beiden Positionswerten nicht mehr der Soll-Beziehung entsprechen. Somit kann über den Vergleich der beiden Positionswerte unter Einbeziehung der Prüfinformation bzw. der Soll-Beziehung ermittelt werden, ob die Positionserfassung valide ist, d.h., ob die Erfassungseinrichtung 5 in der Lage ist, die Position des Antriebskörpers 3 mit hinreichender Genauigkeit zu bestimmen.

Eine Beeinträchtigung der Positionserfassungsgenauigkeit kann insbesondere dann auftreten, wenn sich die Magnetanordnung 4 erwärmt oder dreht.

Letzteres ist möglich, wenn der Antriebskörper 3 frei drehbar ist und das Magnetfeld der Magnetanordnung 4 in der Drehrichtung des Antriebskörpers 3 inhomogen ist.

Die Erfassungseinrichtung 5 ist ausgebildet, in Abhängigkeit des Ergebnisses der Validitätsprüfung ein Validitätssignal auszugeben. Der Wert des Validitätssignals hängt davon ab, ob die Erfassungseinrichtung 5 die Positionserfassung für valide oder für nicht valide erachtet hat. Im gezeigten Beispiel ist die Erfassungseinrichtung 5 ausgebildet, das Validitätssignal an die Schnittstelle 18 auszugeben. Die Schnittstelle 18 ist ausgebildet, mit einer hier nicht gezeigten Steuereinheit, beispielsweise einer SPS, insbesondere über ein Bussystem zu kommunizieren und dieser den Validitätszustand der Positionserfassung mitzuteilen.

Die Schnittstelle 18 ist ferner ausgebildet, von der Steuereinheit Befehle zu empfangen, und diese an die Erfassungseinrichtung 5 zu übermitteln. Beispielsweise kann die Steuereinheit auf Basis des mitgeteilten Validitätszustands einen Befehl an die Schnittstelle 18 senden, der eine Neubestimmung der Initialisierungsparameter instruiert. Bei Empfang dieses Befehls führt die Empfangseinrichtung 5 eine Bestimmung der Initialisierungsparameter in der vorstehend beschriebenen Weise aus.

**Patentansprüche**

1. Antriebsvorrichtung (10) zur Bereitstellung einer Antriebsbewegung (1) eines Antriebskörpers (3), umfassend den Antriebskörper (2), der eine Magnetanordnung (4) umfasst, wobei die Antriebsvorrichtung (10) wenigstens zwei voneinander beabstandete Magnetfeldsensorelemente (7, 8, 9, 11, 12, 13) umfasst, die ausgebildet sind, Magnetfeldmesswerte bereitzustellen, und wobei die Antriebsvorrichtung (10) eine Erfassungseinrichtung (5) umfasst, die ausgebildet ist, eine Position (6) des Antriebskörpers (3) basierend auf einem oder mehreren der Magnetfeldmesswerte zu erfassen, wobei die Erfassungseinrichtung (5) ausgebildet ist, gemäß wenigstens zwei Magnetfeldmesswerten von wenigstens zwei als auf demselben Chip befindliche Pixelzellen derselben Sensorzelle (14, 15, 16) ausgebildete Magnetfeldsensorelementen (7, 8, 9, 11, 12, 13) oder gemäß wenigstens zwei Positionswerten, die auf wenigstens zwei Magnetfeldmesswerten basieren, die von wenigstens zwei als auf demselben Chip befindliche Pixelzellen derselben Sensorzelle ausgebildete Magnetfeldsensorelementen erfasst werden, sowie unter Einbeziehung einer Prüfinformation, die eine Soll-Beziehung zwischen Magnetfeldmesswerten bzw. zwischen Positionswerten darstellt, die Validität der Positionserfassung zu prüfen und in Abhängigkeit von dem Ergebnis der Prüfung ein Validitätssignal bereitzustellen.

2. Antriebsvorrichtung (10) nach Anspruch 1, **dadurch gekennzeichnet, dass** der Antriebskörper (3) längs eines Verschiebewegs (2) verschiebbar ist.

3. Antriebsvorrichtung (10) nach Anspruch 2, **dadurch gekennzeichnet, dass** die Erfassungseinrichtung (5) ausgebildet ist, unter Verwendung eines oder mehrerer Initialisierungsparameter jeweils einen Magnetfeldmesswert von einem Magnetfeldmesselement in einen Positionswert umzusetzen.

4. Antriebsvorrichtung (10) nach Anspruch 3, **dadurch gekennzeichnet, dass** die Erfassungseinrichtung (5) ausgebildet ist, auf Basis von erfassten Magnetfeldmesswerten wenigstens einen Initialisierungsparameter zu bestimmen.

5. Antriebsvorrichtung (10) nach Anspruch 4, **dadurch gekennzeichnet, dass** die Erfassungseinrichtung (5) ausgebildet ist, gemäß dem Validitätssignal wenigstens einen Initialisierungsparameter neu zu bestimmen.

6. Antriebsvorrichtung (10) nach einem der Ansprüche 1 bis 5, **dadurch gekennzeichnet, dass** die Antriebsvorrichtung (10) ausgebildet ist, in Abhängigkeit von dem Validitätssignal ein Fehlersignal auszugeben und/oder einen sicheren Zustand einzunehmen.

7. Antriebsvorrichtung (10) nach einem der Ansprüche 1 bis 6, **dadurch gekennzeichnet, dass** die Erfassungseinrichtung (5) ausgebildet ist, wenigstens zwei Magnetfeldmesswerte, die jeweils die größte Magnetfeldstärke anzeigen, auszuwählen und die Validitätprüfung gemäß den ausgewählten Magnetfeldmesswerten bzw. gemäß Positionswerten, die auf den ausgewählten Magnetfeldmesswerten basieren, durchzuführen.

8. Antriebsvorrichtung (10) nach einem der Ansprüche 1 bis 7, **dadurch gekennzeichnet, dass** die Erfassungseinrichtung (5) ausgebildet ist, die Validitätsprüfung gemäß wenigstens zwei Magnetfeldmesswerten, die von wenigstens zwei benachbarten Magnetfeldsensorelementen (7, 8, 9, 11, 12, 13) erfasst werden, bzw. gemäß Positionswerten, die auf diesen Magnetfeldmesswerten basieren, durchzuführen.

9. Antriebsvorrichtung (10) nach einem der Ansprüche 1 bis 8, **dadurch gekennzeichnet, dass** die Prüfinformation den Abstand (17) zwischen zwei Magnetfeldsensorelementen (7, 8, 9, 11, 12, 13) darstellt oder auf diesem basiert.

10. Verfahren zur Validitätsprüfung einer Erfassung einer Position (6) eines Antriebskörpers (3), der eine Magnetanordnung (4) aufweist, mit den Schritten: Erfassen (S1) von wenigstens zwei Magnetfeldmesswerten mittels wenigstens zweier voneinander beabstandeter als auf demselben Chip befindliche Pixelzellen derselben Sensorzelle (14, 15, 16) ausgebildeter Magnetfeldsensorelemente (7, 8, 9, 11, 12, 13), Prüfen der Validität der Positionserfassung gemäß den wenigstens zwei erfassten Magnetfeldmesswerten oder gemäß wenigstens zwei auf den wenigstens zwei Magnetfeldmesswerten basierten Positionswerten sowie unter Einbeziehung einer gespeicherten Prüfinformation, die eine Soll-Beziehung zwischen Magnetfeldmesswerten bzw. zwischen Positionswerten darstellt, und Bereitstellen eines Validitätssignals in Abhängigkeit von dem Ergebnis der Prüfung.

**Claims**

1. Drive device (10) for providing a driving movement (1) of a drive body (3), comprising the drive body (2), which comprises a magnet arrangement (4), wherein the drive device (10) comprises at least two magnetic field sensor elements (7, 8, 9, 11, 12, 13) which are spaced apart from one another and are adapted to provide magnetic field measured values, and wherein the drive device (10) comprises a detection apparatus (5) which is adapted to detect a position (6) of the drive body (3) on the basis of one or more of the magnetic field measured values, wherein the detection apparatus (5) is adapted to check, in accordance with at least two magnetic field measured values from at least two magnetic field sensor elements (7, 8, 9, 11, 12, 13) adapted as pixel cells which are arranged on the same chip and belong to the same sensor cell (14, 15, 16), or in accordance with at least two position values, which are based on at least two magnetic field measured values detected by at least two magnetic field sensor elements (7, 8, 9, 11, 12, 13) adapted as pixel cells which are arranged on the same chip and belong to the same sensor cell (14, 15, 16), and taking into account checking information which represents a target relationship between magnetic field measured values or position values, respectively, the validity of the position detection and to provide a validity signal as a function of the result of the check.

2. Drive device (10) according to Claim 1, **characterised in that** the drive body (3) is displaceable along a displacement path (2).

3. Drive device (10) according to Claim 2, **characterised in that** the detection apparatus (5) is adapted to convert a magnetic field measured value from a magnetic field element into a position value using one or more initialisation parameters.

4. Drive device (10) according to Claim 3, **characterised in that** the detection apparatus (5) is adapted to determine at least one initialisation parameter on the basis of detected magnetic field measured values.

5. Drive device (10) according to Claim 4, **characterised in that** the detection apparatus (5) is adapted to re-determine at least one initialisation parameter in accordance with the validity signal.

6. Drive device (10) according to any one of Claims 1 to 5, **characterised in that** the drive device (10) is adapted to output an error signal and/or to adopt a safe state as a function of the validity signal.

7. Drive device (10) according to any one of Claims 1 to 6, **characterised in that** the detection apparatus (5) is adapted to select at least two magnetic field measured values which indicate the greatest magnetic field strength and to carry out the validity check in accordance with the selected magnetic field measured values or, respectively, in accordance with the position values which are based on the selected magnetic field measured values.

8. Drive device (10) according to any one of Claims 1 to 7, **characterised in that** the detection apparatus (5) is adapted to carry out the validity check in accordance with at least two magnetic field measured values, which are detected by at least two adjacent magnetic field sensor elements (7, 8, 9, 11, 12, 13), or, respectively, in accordance with position values, which are based on these magnetic field measured values.

9. Drive device (10) according to any one of Claims 1 to 8, **characterised in that** the checking information represents the distance (17) between two magnetic field sensor elements (7, 8, 9, 11, 12, 13) or is based thereon.

10. Method for checking the validity of a detection of a position (6) of a drive body (3), which comprises a magnet arrangement (4), having the steps: detecting (S1) at least two magnetic field measured values by means of at least two magnetic field sensor elements (7, 8, 9, 11, 12, 13) spaced apart from one another and adapted as pixel cells which are arranged on the same chip and belong to the same sensor cell (14, 15, 16), checking the validity of the position detection in accordance with the at least two detected magnetic field measured values or in accordance with at least two position values based on the at least two magnetic field measured values and taking into account stored checking information which represents a target relationship between magnetic field measured values or, respectively, between position values and providing a validity signal as a function of the result of the check.

## Revendications

1. Dispositif d'entraînement (10) pour fournir un déplacement par entraînement (1) d'un corps d'entraînement (3), comprenant le corps d'entraînement (2), qui comprend un ensemble magnétique (4), dans lequel le dispositif d'entraînement (10) comprend au moins deux éléments de capteur de champ magnétique (7, 8, 9, 11, 12, 13) tenus à distance l'un de l'autre, qui sont réalisés pour fournir des valeurs de mesure de champ magnétique, et dans lequel le dispositif d'entraînement (10) comprend un système de détection (5) qui est réalisé pour détecter une position (6) du corps d'entraînement (3) sur la base d'une ou de plusieurs des valeurs de mesure de champ magnétique, dans lequel le système de détection (5) est réalisé pour vérifier la validité de la détection de position selon au moins deux valeurs de mesure de champ magnétique d'au moins deux éléments de capteur de champ magnétique (7, 8, 9, 11, 12, 13) réalisés en tant que cellules de pixel, se trouvant sur la même puce, de la même cellule de capteur (14, 15, 16) ou selon au moins deux valeurs de position, qui sont sur la base d'au moins deux valeurs de mesure de champ magnétique, qui sont détectées par au moins deux éléments de capteur de champ magnétique réalisés en tant que cellules de pixel, se trouvant sur la même puce, de la même cellule de capteur, et en intégrant également une information de vérification, qui représente une relation théorique entre des valeurs de mesure de champ magnétique ou entre des valeurs de position et pour fournir, en fonction du résultat de la vérification, un signal de validité.

2. Dispositif d'entraînement (10) selon la revendication 1, **caractérisé en ce que** le corps d'entraînement (3) peut être coulissé le long d'un trajet de coulissement (2).

3. Dispositif d'entraînement (10) selon la revendication 2, **caractérisé en ce que** le système de détection (5) est réalisé pour convertir, en utilisant un ou plusieurs paramètres pour l'initialisation, respectivement une valeur de mesure de champ magnétique d'un élément de mesure de champ magnétique en une valeur de position.

4. Dispositif d'entraînement (10) selon la revendication 3, **caractérisé en ce que** le système de détection (5) est réalisé pour définir au moins un paramètre pour l'initialisation sur la base de valeurs de mesure de champ magnétique détectées.

5. Dispositif d'entraînement (10) selon la revendication 4, **caractérisé en ce que** le système de détection (5) est réalisé pour définir à nouveau au moins un paramètre pour l'initialisation selon le signal de validité.

6. Dispositif d'entraînement (10) selon l'une quelconque des revendications 1 à 5, **caractérisé en ce que** le dispositif d'entraînement (10) est réalisé pour émettre un signal d'erreur en fonction du signal de validité et/ou pour adopter un état de sécurité.

7. Dispositif d'entraînement (10) selon l'une quelconque des revendications 1 à 6, **caractérisé en ce que** le système de détection (5) est réalisé pour sélectionner au moins deux valeurs de mesure de champ magnétique, qui indiquent respectivement l'intensité de champ magnétique la plus importante, et pour mettre en œuvre la vérification de validité selon les valeurs de mesure de champ magnétique sélectionnées ou selon des valeurs de position, qui sont sur la base des valeurs de mesure de champ magnétique sélectionnées.

8. Dispositif d'entraînement (10) selon l'une quelconque des revendications 1 à 7, **caractérisé en ce que** le système de détection (5) est réalisé pour mettre en œuvre la vérification de validité selon au moins deux valeurs de mesure de champ magnétique, qui sont détectées par au moins deux éléments de capteur de champ de mesure (7, 8, 9, 11, 12, 13) adjacents, ou selon des valeurs de position, qui sont sur la base desdites valeurs de mesure de champ magnétique.

9. Dispositif d'entraînement (10) selon l'une quelconque des revendications 1 à 8, **caractérisé en ce que** l'information de vérification représente l'espacement (17) entre deux éléments de capteur de champ magnétique (7, 8, 9, 11, 12, 13) ou sont sur la base de celui-ci.

10. Procédé de vérification de validité d'une détection d'une position (6) d'un corps d'entraînement (3), qui présente un ensemble magnétique (4), avec les étapes : de détection (S1) d'au moins deux valeurs de mesure de champ magnétique au moyen d'au moins deux éléments de capteur de champ magnétique (7, 8, 9, 11, 12, 13) tenus à distance l'un de l'autre, réalisés en tant que cellules de pixel, se trouvant sur la même puce, de la même cellule de capteur (14, 15, 16), de vérification de la validité de la détection de position selon les au moins deux valeurs de mesure de champ magnétique détectées ou selon au moins deux valeurs de position étant sur la base des au moins deux valeurs de mesure de champ magnétique ainsi qu'en intégrant une information de vérification stockée, qui représente une relation théorique entre des valeurs de mesure de champ magnétique ou entre des valeurs de position, et de fourniture d'un signal de validité en fonction du résultat de la vérification.

EP 3 283 849 B1

Fig. 1

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 69510357 T2
- EP 1777501 A1
- US 20050189938 A1